# EUROPEAN PATENT APPLICATION

(11) **EP 0 881 684 A1**
(43) Date of publication of application: **02.12.1998**
(21) Application number: 98109171.3
(22) Date of filing: 20.05.1998
(51) Int. Cl.: H01L 27/08

(54) **Integrated circuit resistor structure**

(30) Priority: 29.05.1997 CH 1265/97; 27.06.1997 EP 97110555
(71) Applicant: EM Microelectronic-Marin SA, 2074 Marin (CH)
(72) Inventor: Divoux, Jean-Noel, 2300 La Chaux-de-Fonds (CH)
(74) Representative: Balsters, Robert

(57) **Abstract**

The present invention concerns an integrated circuit resistor structure (10) comprising a well (1) formed in a substrate (2) and having a first type of conductivity, and a diffusion zone (3) formed in said well (1) and having a second type of conductivity different from said first type of conductivity. Said well (1) is provided with first and second contact terminals (5B, 7B), so as to form a first resistor (Rwell) in said well (1), and said diffusion zone (3) is provided with third and fourth contact terminals (5A, 7A) so as to form a second resistor (Rdiff) in said diffusion zone (3). This structure further comprises means (11) for connecting external terminals (M, N) with said first, second, third and fourth contact terminals, so as to form a selected combination of said first and second resistors among a plurality of combinations.

## Description

The present invention concerns the field of integrated circuit resistor structures.

There exist different types of resistor structures formed in integrated circuits, according to the prior art. In particular, an integrated circuit resistor structure is conventionally made comprising a diffusion zone of a first type of conductivity, formed in a well of a second type of conductivity different from the first type of conductivity. In an integrated circuit substrate, an insulating zone intended to insulate the diffusion zone from the other components connected on the same substrate, is commonly called a 〈〈 well 〉〉.

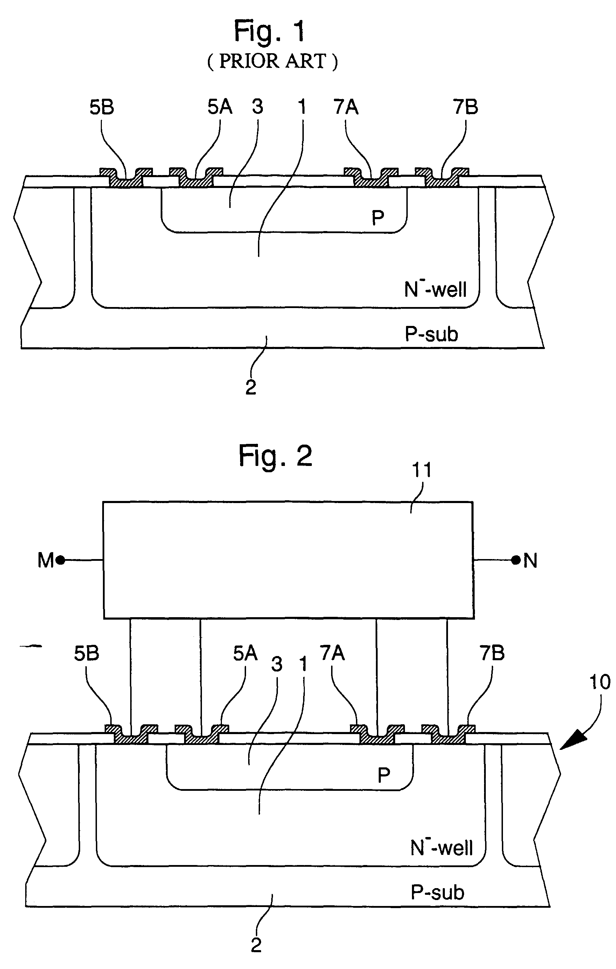

Japanese application No 01268049 discloses an integrated circuit device including a resistor structure of the aforementioned type, this structure being shown schematically in Figure 1 of the present description. A well 1 is formed in a substrate 2, by implantation of impurities of a first type of conductivity in said substrate. A resistor is then formed by a diffusion zone 3 in well 1 by implantation of impurities of a second type of conductivity in well 1. The resistor structure includes two contact terminals 5A and 7A arranged so as to form a first resistor Rdiff in diffusion zone 3, and intended to be connected to another component, via contact terminals arranged outside said resistor structure. The resistor structure further includes two additional contact terminals 5B and 7B arranged so as to form a second resistor Rwell in well 1.

The aforementioned Japanese application shows that the connection between contact terminals 5A, 5B, 7A and 7B is arranged so that resistor Rwell is connected in parallel with resistor Rdiff.

Such structures of the type shown in Figure 1 have the drawback of occupying a significant surface area across the substrate, in order to form a resistor of high resistance characteristics. Moreover, the resistivity and temperature dependence characteristics of said resistor are determined by the nature of the material selected for forming the diffusion zone, which may be particularly disadvantageous for certain applications of such a resistor.

An object of the present invention is to provide an integrated circuit resistor structure capable of providing variable resistivity and temperature dependence characteristics.

Another object of the present invention is to provide such a structure which answers conventional industrial criteria of packing density, complexity and cost.

These objects, in addition to others, are achieved by the integrated circuit resistor structure according to claim 1.

One advantage of the resistor structure according to the present invention is obtaining a greater resistance than the single resistance of the diffusion zone, while occupying the same surface area.

Another advantage of the resistor structure according to the present invention is being able to obtain different resistor configurations from the same resistor structure, these configurations each having specific resistivity and temperature dependence characteristics, able to be adapted to different use requirements.

These objects, features and advantages of the present invention, in addition to others, will appear more clearly upon reading the detailed description of a preferred embodiment of the invention, given solely by way of example, with reference to the annexed drawings, in which :
- Figure 1 already cited shows an integrated circuit resistor structure according to the prior art;
- Figure 2 shows an integrated circuit resistor structure according to the present invention;
- Figures 3A to 3D show four equivalent electric diagrams corresponding to different combinations of the structure of Figure 2, respectively;
- Figure 4A to 4D show a first embodiment of the connection means of the structure of Figure 2, according to the four equivalent electric diagrams of Figures 3A to 3D, respectively ; and
- Figure 5 shows a second embodiment of the connection means of the structure of Figure 2.

Figure 2 shows an integrated circuit resistor structure 10 according to the present invention.

It will be noted that structure 10 is close to the conventional structure shown in Figure 1. Thus, the components of Figure 2 designated by the same numerals as the components of Figure 1 are the same.

Structure 10 includes a well 1 having a first type of conductivity, this well being provided in a substrate 2, and a diffusion zone 3 having a second type of conductivity, this zone being provided in well 1.

Structure 10 further includes a first pair of contact terminals 5A and 7A provided at the surface of diffusion zone 3, these terminals being arranged so as to form a first resistor Rdiff in diffusion zone 3, i.e. the path for electric charges between terminal 5A and terminal 7A along a path included in diffusion zone 3, and a second pair of contact terminals 5B and 7B, provided at the surface of well 1, so as to form a second resistor Rwell in well 1, i.e. the path for electric charges between terminal 5A and terminal 5B along a path included in well 1.

Structure 10 is further connected to another component, via external contact terminals M and N arranged so as to form the connection of this component to resistors Rwell and Rdiff. This component can be made in a different integrated circuit substrate from said substrate 2, or in a zone of said substrate 2 electrically insulated from well 1.

Structure 10 is also fitted with means 11 for connecting contact terminals 5A, 7B, 5B and 7B to each other, these connection means being arranged so as to form a selected combination of resistors Rwell and Rdiff.

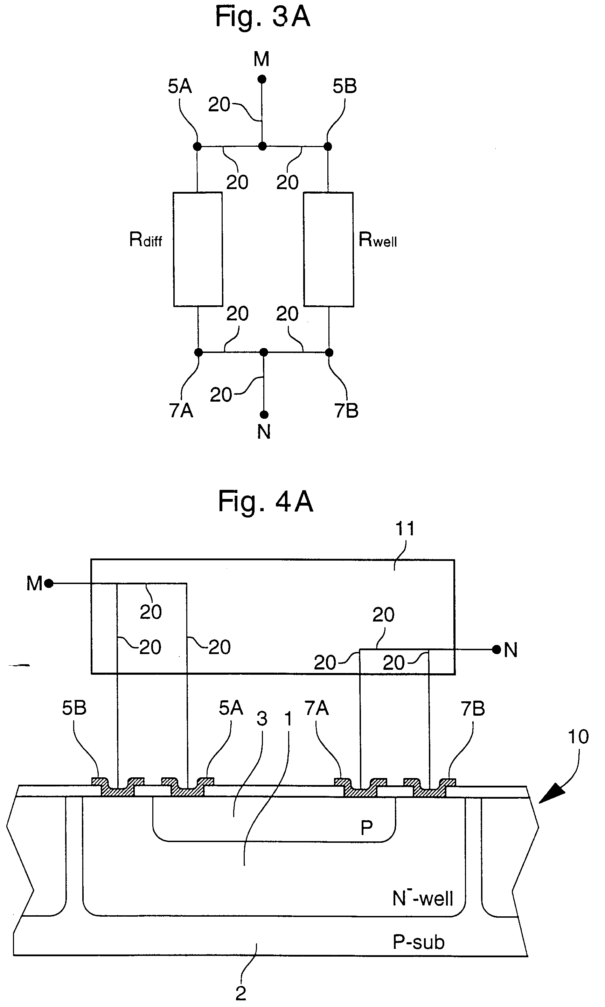

Different connection configurations may be made in structure 10. Figures 3A to 3D show four equivalent electric diagrams corresponding to four different selected combinations of resistors Rwell and Rdiff, given solely by way of example.

It is to be noted, in Figures 3A to 3D, that numerals 5A, 7A, 5B and 7B designate similar contact terminals to those designated by the same numerals in Figure 2.

Figure 3A shows the electric diagram equivalent to the fist combination wherein resistors Rdiff and Rwell are connected in parallel between terminals M and N. For this purpose, the aforementioned connection means are arranged so that they connect, in this configuration, terminal M to terminals 5A and 5B, and terminal N to terminals 7A and 7B.

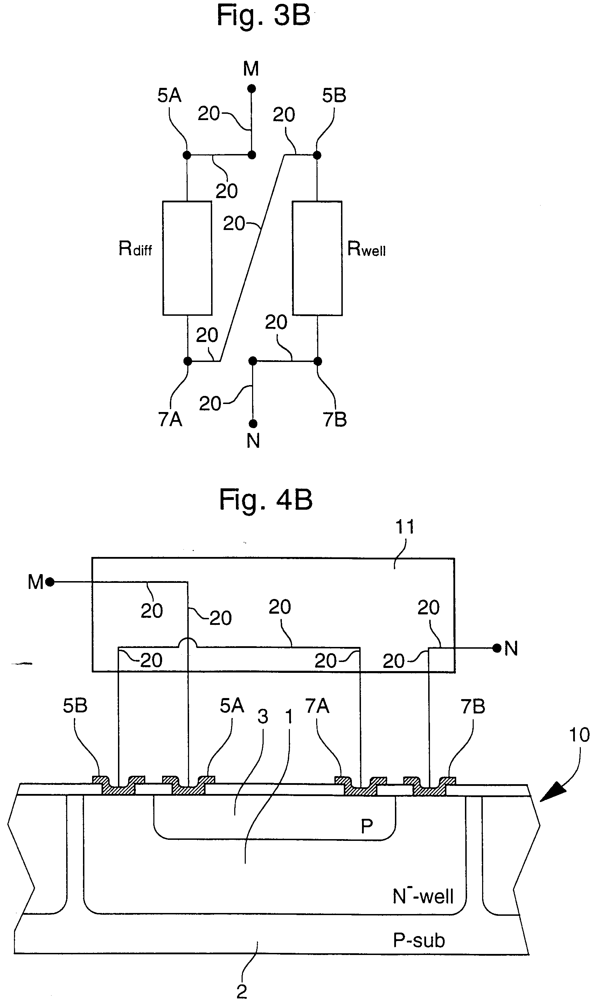

Figure 3B shows the electric diagram equivalent to the second combination wherein resistors Rdiff and Rwell are connected in series between terminals M and N. For this purpose, the aforementioned connection means are arranged so that they connect, in this configuration, terminal M to terminal 5A, terminal N to terminal 7B, and terminal 7A to terminal 5B.

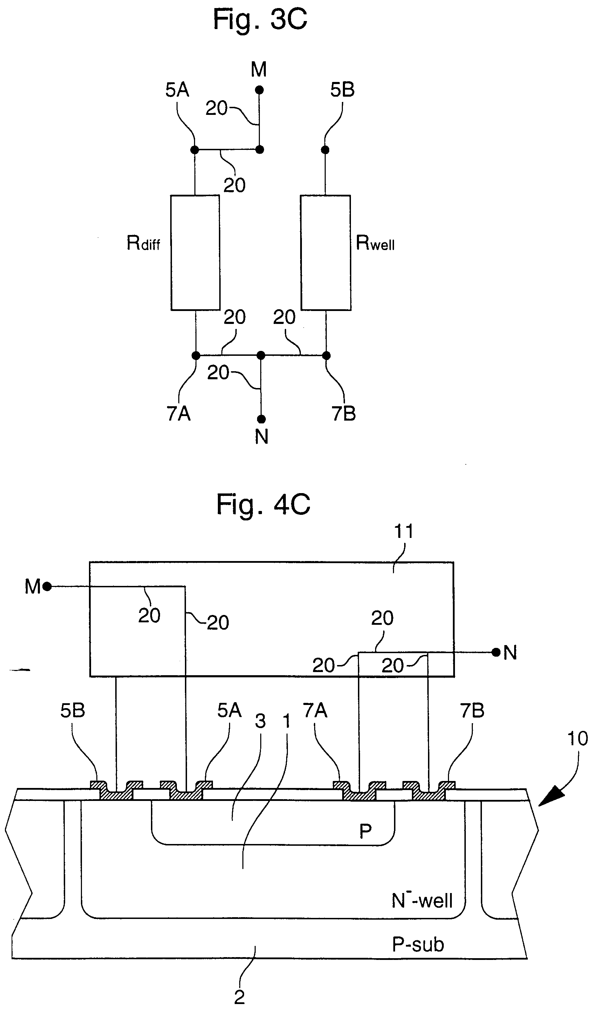

Figure 3C shows the electric diagram equivalent to the third combination wherein only resistor Rdiff is connected between terminals M and N. This configuration is close to that described hereinbefore, with reference to Figure 1, showing an integrated circuit resistor structure according to the prior art. For this purpose, the aforementioned connection means are arranged so that they connect, in this configuration, terminal M to terminal 5A, and terminal N to terminal 7A. Preferably one of terminals 5B and 7B, for example terminal 7B, is connected to one of terminals 5A and 7A, for example terminal 7A, so as to bias well 1, and to oppositely bias the junction between well 1 and diffusion zone 3, as is shown by Figure 3C. As a variant, terminals 5B and 7B can be not connected, the voltage of well 1 then being floating.

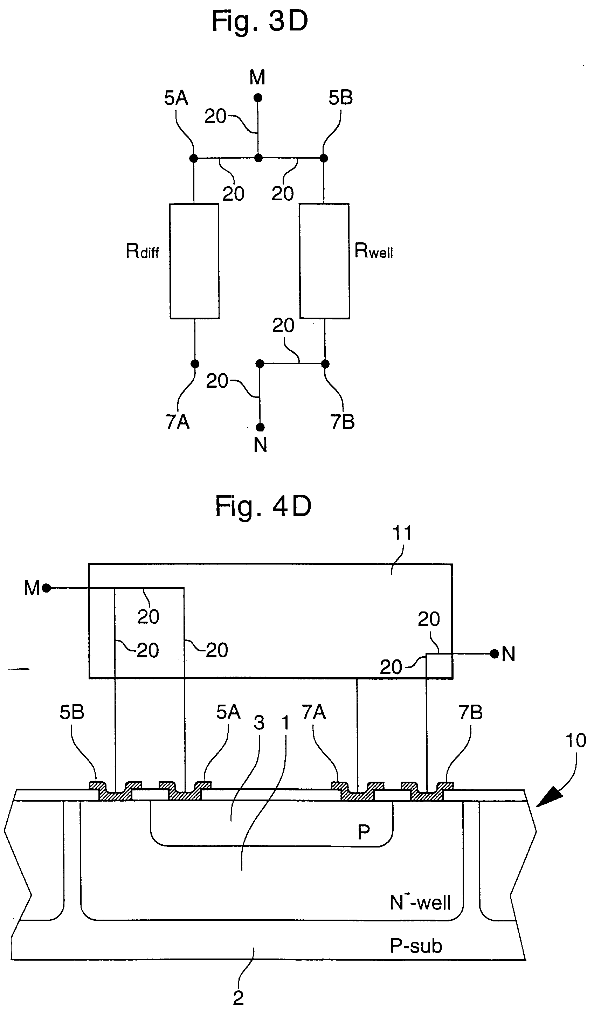

Figure 3D shows the electric diagram equivalent to the fourth combination wherein only resistor Rwell is connected between terminals M and N. For this purpose, the aforementioned connection means are arranged so that they connect, in this configuration, terminal M to terminal 5B, and terminal N to terminal 7B. Preferably one of terminals 5B and 7B, for example terminal 5B, is connected to one of terminals 5A and 7A, for example terminal 5A, so as to bias well 1, and to oppositely bias the junction between well 1 and diffusion zone 3, as is shown by Figure 3D. As a variant, terminals 5B and 7B can be not connected, the voltage of well 1 then being floating.

Figure 4A to 4D show a first embodiment of connection means 11 of structure 10 of Figure 2, according to the four electric diagrams of Figures 3A to 3D respectively.

Referring to Figure 4A, connection means 11 is formed by six conductive strips 20 arranged for example in substrate 2. Strips 20 are connected to form the electric diagram of Figure 3A.

Figure 4B is a similar figure to Figure 4A, wherein connection means 11 comprises seven conductive strips 20. These strips are arranged to form the electric diagram of Figure 3B.

Figures 4C and 4D are similar figures to Figure 4A, wherein connection means 11 comprises five conductive strips 20. These strips are arranged to form the electric diagrams of Figures 3C and 3D, respectively.

It is noted in that numerals 20 in Figures 3A to 3D designate conductive strips 20 in the equivalent electric diagram of Figures 3A to 3D, respectively.

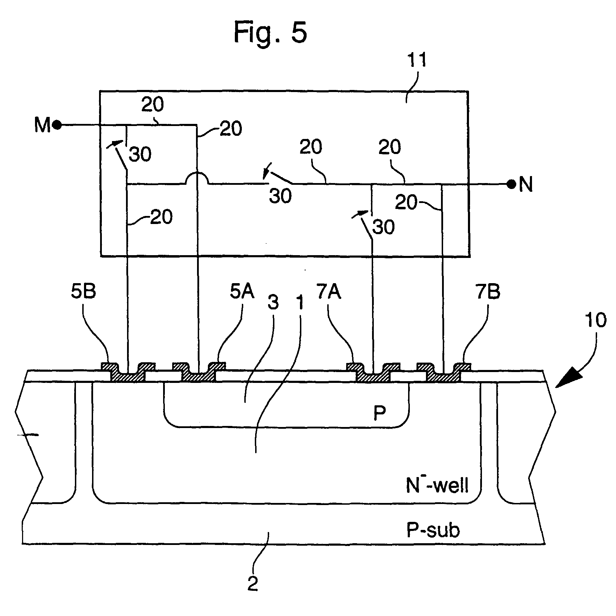

Figure 5 show a second embodiment of connection means 11 of the structure of Figure 2.

Referring to Figure 5, connection means 11 is formed by an arrangement of conductive strips 20 and switches 30. In the example of Figure 5, three switches 30 are connected with conductive strips 20 between contact terminals 5A, 5B, 7A and 7B and external terminals M and N.

Each of switches 30 can be switched in a position 〈〈 ON 〉〉 or 〈〈 OFF 〉〉, in response to a control signal which can be provided by control means (not shown in Figure 5). Thus, connection means 11 can be configured upon demand in any of the four electric diagrams of Figures 3A to 3D. In other words, switches 30 allow the selection of said selected combination.

Therefore, connection means 11 can be sequentially configured according to the four diagrams of Figures 3A to 3D. For instance, during a two-phase period, connection means 11 can be in the configuration of the electric diagram of Figure 3A during the first phase, and in the configuration of the electric diagram of Figure 3B during the second phase.

An advantage of the resistor structure according to the present invention is being able to obtain different resistor configurations from the same resistor structure, these configurations each having specific resistivity and temperature dependence characteristics, able to be adapted to different use requirements.

Specific electric and heat properties are associated with each of these configurations.

Solely by way of illustration, the Applicant of the present invention has measured some characteristic values of configurations A to D described in relation to Figures 3A to 3D, respectively. These values are the total resistance measured at 25°C over one of the aforementioned configurations, this resistance being designated Rₜₒₜ, the sheet resistance associated with resistance Rₜₒₜ, this resistance being designated R/□ being known to those skilled in the art, and the temperature coefficient designated ΔR/Ro, this coefficient being equal to the total resistance variation for a temperature variation of 1°C. Table I hereinafter shows these values for configurations A to D formed in a structure 10 which has the following dimensions. Well 1 of this structure has a depth equal to 2.0 µm, a length equal to 1.8 mn and a width equal to 8 µm, and diffusion zone 3 of this structure has a depth equal to 0.44 µm, a length equal to 1.8 mn and a width equal to 2 µm.

**Table I**

| Configuration | Rtot (KΩ) | R/□ (Ω/□) | ΔR/Ro (%/°C) |
|---|---|---|---|
| A | 40.5 | 45.8 | 1.4 |
| B | 560.3 | 2376.9 | 4.4 |
| C | 44.1 | 49.9 | 1.2 |
| D | 516.5 | 2327.0 | 4.7 |

It is to be noted that the different configurations A to D of the same structure 10 allow total resistances Rtot to be achieved comprised between 40.5 and 560.3 KΩ, as well as temperature coefficients ΔR/Ro varying between 1.2 and 4.7%/°C.

Moreover, those skilled in the art will note that configuration B wherein well and diffusion zones are connected in series has a sheet resistance of approximately 2380 KΩ/□. Thus, structure 10 is particularly advantageous in that it allows a resistor configuration to be achieved having a sheet resistance two times greater than that of a well having the same geometry, and not including a diffusion zone (typically 1530 KΩ/□).

It is noted that the structure according to the present invention can be made by a manufacturing method including known manufacturing steps.

As an example, and referring to Figures 4A to 4D, a well 1 is formed in a substrate 2 by implanting impurities of a first type of conductivity, masking the other zones of the substrate. Likewise, a diffusion zone 3 is formed by implanting impurities of a second type of conductivity. Contact terminals 5A, 7A, 5B and 7B are then formed as well as connection means 11 between said terminals, via conventional steps consisting of: depositing a metal layer over substrate 2, in particular over well 1 and diffusion zone 3; depositing a layer of photoresist over said metal layer; insulating and developing the photoresist layer; etching the exposed zones of the metal layer; and eliminating the remaining photoresist.

As far as Figure 5 is concerned, structure 10 can be made by a similar manufacturing method. Preferably, switches 30 can be preferably conventional MOS-FET transistors formed in substrate 2, and said control means is a conventional microprocessor.

Those skilled in the art will note that said connection means, as well as said contact terminals, may advantageously be formed when the different connection structures of the circuits formed in said substrate are made.

An advantage of such a manufacturing method is including already known manufacturing steps, which make said structure inexpensive and easy to make.

It goes without saying for those skilled in the art that the detailed description hereinbefore can undergo various modifications without departing from the scope of the present invention.

## Claims

1. Integrated circuit resistor structure (10) comprising :
- a well (1) formed in a substrate (2), and having a first type of conductivity, said well (1) being provided with first and second contact terminals (5B, 7B), so as to form a first resistor (Rwell) in said well (1); and
- a diffusion zone (3) formed in said well (1), and having a second type of conductivity different from said first type of conductivity, said diffusion zone (3) being provided with third and fourth contact terminals (5A, 7A) so as to form a second resistor (Rdiff) in said diffusion zone (3),
said structure (10) being characterized in that it further comprises means (11) for connecting external terminals (M, N) with said first, second, third and fourth contact terminals, so as to form a selected combination of said first and second resistors among a plurality of combinations.

2. Structure (10) according to claim 1,
characterized in that said connection means (11) are formed by a plurality of conductive strips (20) connected with said first, second, third and fourth contact terminals (5B, 7B, 5A, 7A), so as to form the electric diagram corresponding to said selected combination.

3. Structure (10) according to claim 1,
characterized in that said connection means (11) are formed by a plurality of conductive strips (20) and a plurality of switches (30) connected with said first, second, third and fourth contact terminals (5B, 7B, 5A, 7A), said switches (30) being switched in a position ON or OFF so as to allow the selection of any of said combinations.

4. Structure (10) according to claim 1,
characterized in that said selected combination is such that said first and second resistors (Rwell, Rdiff) are connected in parallel.

5. Structure (10) according to claim 1,
characterized in that said selected combination is such that said first and second resistors (Rwell, Rdiff) are connected in series.

6. Structure (10) according to claim 1,
characterized in that said selected combination is such that only said first resistor (Rwell) is connected.

7. Structure (10) according to claim 1,
characterized in that said selected combination is such that only said second resistor (Rdiff) is connected.

8. Structure (10) according to claim 3,
characterized in that said switches (30) are formed by MOS-FET transistors.

9. Structure (10) according to claim 8,
characterized in that said transistors are controlled by control means.

10. Structure (10) according to claim 9,
characterized in that said control means is a microprocessor.

11. Structure (10) according to claim 1,
characterized in that said connection means (11) is formed monolithically in said substrate (2).
